(19) Europäisches Patentamt / European Patent Office / Office européen des brevets

(11) **EP 4 679 114 A1**

(12) **EUROPEAN PATENT APPLICATION**
published in accordance with Art. 153(4) EPC

(43) Date of publication:
14.01.2026 Bulletin 2026/03

(21) Application number: 24766707.4

(22) Date of filing: 25.01.2024

(51) International Patent Classification (IPC):
$G01R\ 31/392^{(2019.01)}$    $G01R\ 31/367^{(2019.01)}$
$G01R\ 31/3828^{(2019.01)}$    $G01R\ 31/388^{(2019.01)}$
$G01R\ 31/389^{(2019.01)}$    $G01R\ 31/396^{(2019.01)}$
$H01M\ 10/48^{(2006.01)}$    $H02J\ 7/00^{(2026.01)}$

(52) Cooperative Patent Classification (CPC):
G01R 31/367; G01R 31/3828; G01R 31/3842;
G01R 31/387; G01R 31/388; G01R 31/389;
G01R 31/392; G01R 31/396; H01M 10/48;
H02J 7/00; Y02E 60/10

(86) International application number:
PCT/JP2024/002188

(87) International publication number:
WO 2024/185332 (12.09.2024 Gazette 2024/37)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 08.03.2023 JP 2023035508

(71) Applicant: HITACHI HIGH-TECH CORPORATION
Tokyo 105-6409 (JP)

(72) Inventors:
• KONISHI Hiroaki
  Tokyo 100-8280 (JP)
• INOUE Takeshi
  Tokyo 100-8280 (JP)
• UEDA Suguru
  Tokyo 100-8280 (JP)
• HORIKOSHI Nobuya
  Tokyo 105-6409 (JP)
• YONEMOTO Masahiro
  Tokyo 105-6409 (JP)
• MOCHIZUKI Masahito
  Tokyo 105-6409 (JP)
• SUMIKAWA Yosuke
  Tokyo 105-6409 (JP)

(74) Representative: Mewburn Ellis LLP
Aurora Building
Counterslip
Bristol BS1 6BX (GB)

(54) **BATTERY PACK DIAGNOSIS METHOD AND DIAGNOSIS DEVICE**

(57) The invention provides a battery pack diagnosis method that improves calculation accuracy of an energy capacity of a battery pack.

The battery pack diagnosis method includes a step of obtaining detection data including a current and a temperature of a battery pack having a configuration in which a plurality of cells are connected in series and a voltage of each of the cells, a step of obtaining function data of an open circuit voltage and a resistance which are functions of a charging state of each of the cells, a step of creating a resistance table of each of the cells using the function data and the detection data, a step of calculating the charging state of each of the cells using the current, the temperature, and the voltage of each of the cells, a step of calculating a charge capacity of each of the cells, the resistance, and a charging state per cell, a step of calculating an energy capacity of the battery pack using the charge capacity, the charging state per cell, and the resistance, a step of diagnosing a value of the calculated energy capacity of the battery pack, and a step of deleting a value of the energy capacity determined to be an abnormality by the diagnosis and recalculating the energy capacity of the battery pack.

EP 4 679 114 A1

[FIG. 1]

## Description

Technical Field

The present disclosure relates to a battery pack diagnosis method and diagnosis device.

Background Art

A battery pack including a plurality of cells is built in an electric vehicle (EV) or the like.

Since an energy capacity of the battery pack has a correlation with a traveling distance of the EV, a technique for accurately grasping the energy capacity of the battery pack is required.

PTL 1 discloses a battery pack diagnosis method using a system that obtains detection data including a current and a temperature of the battery pack having a configuration in which a plurality of cells are connected in series and a voltage of each of the cells, the method including calculating an imbalance amount and a resistance, which are estimated values of a charging state of each of the cells when the battery pack is fully charged, by using the current, the temperature, the voltage of each of the cells, a charging state function of an open circuit voltage, and a resistance table, and calculating an energy capacity of the battery pack by using a charge capacity, the imbalance amount, and the resistance.

In this specification, a state of charge of each cell in the battery pack is referred to as an "SOC". The open circuit voltage is referred to as an "OCV".

Citation List

Patent Literature

PTL 1: WO2022/024885

Summary of Invention

Technical Problem

The calculation of the energy capacity of the battery pack requires data such as a current, a temperature, and a voltage during the battery is operating (traveling and charging). When there is a large error in input data such as the current, the temperature, and the voltage, there will be a large error in the energy capacity of the battery pack that is diagnosed using the above-described data, and therefore data accuracy is important.

In the battery pack diagnosis method disclosed in PTL 1, a method for coping with a case where there is an abnormality in data is not considered.

An object of the present disclosure is to improve calculation accuracy of an energy capacity of a battery pack.

Solution to Problem

A battery pack diagnosis method according to the present disclosure includes a step of obtaining detection data including a current and a temperature of a battery pack having a configuration in which a plurality of cells are connected in series and a voltage of each of the cells, a step of obtaining function data of an open circuit voltage and a resistance which are functions of a charging state of each of the cells, a step of creating a resistance table of each of the cells using the function data and the detection data, a step of calculating the charging state of each of the cells using the current, the temperature, and the voltage of each of the cells, a step of calculating a charge capacity of each of the cells, the resistance, and a charging state of each of the cells, a step of calculating an energy capacity of the battery pack using the charge capacity, the charging state of each of the cells, and the resistance, a step of diagnosing a value of the calculated energy capacity of the battery pack, and a step of deleting a value of the energy capacity determined to be an abnormality by the diagnosis and recalculating the energy capacity of the battery pack.

Advantageous Effects of Invention

According to the present disclosure, the calculation accuracy of the energy capacity of the battery pack can be improved.

Brief Description of Drawings

[FIG. 1] FIG. 1 is a configuration diagram illustrating an example of a battery pack diagnosis system according to an embodiment.

[FIG. 2] FIG. 2 is a configuration diagram illustrating an example of a battery pack built in an electric vehicle 101 illustrated in FIG. 1.

[FIG. 3] FIG. 3 is a table illustrating an example of communication contents from an EV to a server.

[FIG. 4] FIG. 4 is a configuration diagram illustrating an example of a battery table 105 illustrated in FIG. 1.

[FIG. 5] FIG. 5 is a flowchart illustrating an example of processing in an SOC calculation unit 107 illustrated in FIG. 1.

[FIG. 6] FIG. 6 is a flowchart illustrating an example of processing in a battery pack energy capacity calculation unit 109 illustrated in FIG. 1.

[FIG. 7A] FIG. 7A is a graph illustrating a voltage of each cell when an imbalance state occurs in the battery pack.

[FIG. 7B] FIG. 7B is a graph illustrating a voltage of each cell in a state after the imbalance state of the battery pack is eliminated.

[FIG. 8] FIG. 8 is a flowchart illustrating an example of processing in a battery pack energy capacity diagnosis and recalculation unit 111 illustrated in FIG. 1.

[FIG. 9] FIG. 9 is an example of a graph used when an abnormality is diagnosed in an energy capacity of the battery pack in S82 illustrated in FIG. 8.

[FIG. 10A] FIG. 10A is a graph illustrating a case where a diagnosis result of the battery pack is an abnormal value in a specific temperature region.

[FIG. 10B] FIG. 10B is a graph illustrating a case where the diagnosis result of the battery pack is an abnormal value in a specific current region.

Description of Embodiments

The present disclosure relates to a method for transferring data of a battery pack built in an EV to a server and diagnosing an energy capacity of the battery pack and a sensor abnormality in the server.
A device for implementing the present diagnosis method includes a pattern calculated by the server, a pattern calculated only by a terminal in the EV, and a pattern calculated by both the server and the terminal in the EV. A series of units may be implemented as a program in the server, or may be implemented using a program of only the terminal in the EV or programs of both the terminal of the EV and the server.
However, the present disclosure is not limited to the following embodiments, and includes various modifications and applications within the technical concept of the present disclosure. For example, a battery pack diagnosis system to be described below can be applied not only to an EV but also to a home energy management system (HEMS), a building energy management system (BEMS), a factory energy management system (FEMS), and a battery pack for railway and construction machines.
Hereinafter, embodiments of the present disclosure will be described in detail with reference to the drawings.

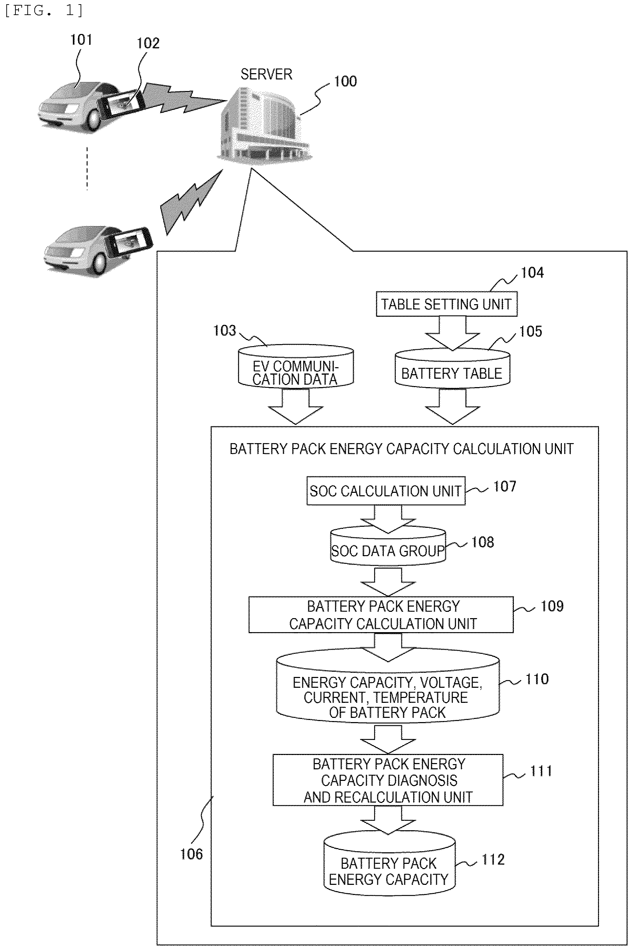

FIG. 1 is a configuration diagram illustrating an example of a battery pack diagnosis system according to an embodiment.
In FIG. 1, the battery pack diagnosis system includes a server 100 (also referred to as a "calculation device" or a "diagnosis device"), a plurality of electric vehicles 101 (EV), and a communication device 102 (for example, a portable terminal such as a smartphone, a Wi-Fi (registered trademark) router, an in-vehicle permanent computer such as a car navigation system, or the like) in each EV. The server 100 includes a storage device 103 (first storage device) that stores EV communication data (a data type will be described later) collected from each EV via the communication device 102, a table setting unit 104, a second storage device that stores a battery table 105, and a battery pack energy calculation unit 106.

The battery pack energy calculation unit 106 includes an SOC calculation unit 107, a third storage device that stores an SOC data group 108, a battery pack energy capacity calculation unit 109, a fourth storage device that stores a data group 110 of an energy capacity, a voltage, a current, a temperature of a battery pack, an energy capacity diagnosis and recalculation unit 111 (battery pack energy capacity calculation unit), and a fifth storage device that stores a data group 112 of an energy capacity of a battery pack.

Although the calculation is performed by the server in FIG. 1 in the embodiment, the calculation may be performed by an edge such as an in-vehicle BMU or an in-vehicle smartphone, or may be performed by the server and the edge such as the in-vehicle BMU or the in-vehicle smartphone. When the calculation is performed by both the server and the in-vehicle BMU or the in-vehicle smartphone, a diagnosis method constructed and improved based on a large amount of data in a cloud may be sent to the edge.

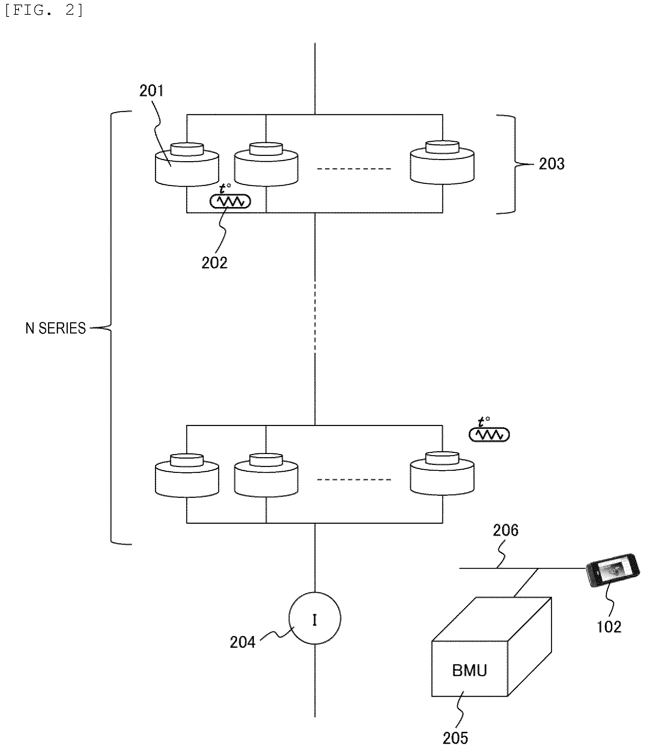

FIG. 2 is a configuration diagram illustrating an example of a battery pack built in the electric vehicle 101 illustrated in FIG. 1.

The battery pack has a configuration in which N cell groups 203, each of which includes L cells 201 connected in parallel, are connected in series. Here, the cell group 203 is regarded as one battery cell. One temperature sensor 202 is attached to each of selected M cell groups 203. In other words, M temperature sensors 202 are provided in the battery pack.

A battery management unit (BMU) 205 that manages the battery pack is built in the EV. The BMU collects voltages of cells connected in parallel in the cell group 203, a current measured by an ammeter 204 (current sensor), and a temperature measured by the M temperature sensors 202 via a network 206 (LAN) in the EV, and calculates a representative SOC of the battery pack.

The BMU can transmit information (detection data) such as a current, a voltage, a temperature, and a representative SOC of the battery pack to the communication device 102 via the LAN. The communication device 102 receives the information and transmits the information to the server 100 (FIG. 1). In this transmission, information is periodically transmitted to the server when the EV is ignited.

Although the battery pack is built in the EV in FIG. 1, the present disclosure is not limited thereto, and the battery pack may be fixed as a stationary power storage device. A diagnosis device is not limited to be provided outside of the EV, and may be installed inside the EV.

Next, communication contents sent from the communication device to the server will be described.

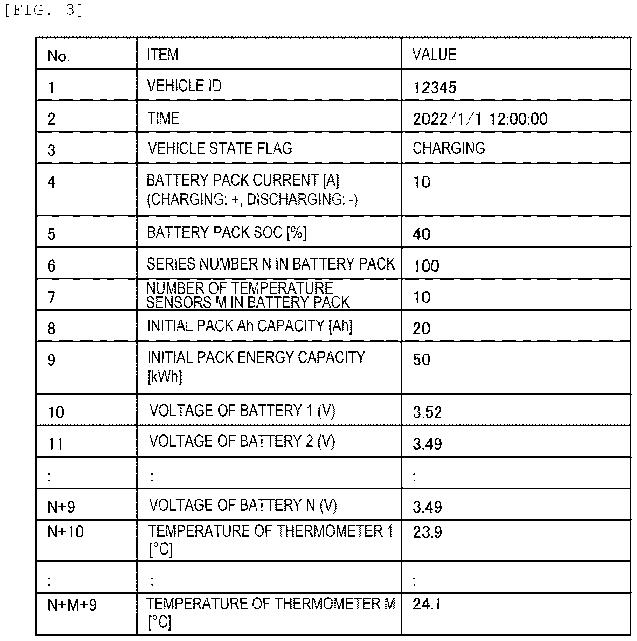

FIG. 3 is a table illustrating an example of communication contents from the EV to the server.

In FIG. 3, a vehicle ID in No. 1 indicates an identification ID of an EV. A time in No. 2 does not indicate a transmission time but indicates a time when a current, a voltage, and a temperature of a battery were measured. A vehicle state flag in No. 3 is a flag indicating that an EV is charged, stopped, or traveling. In this example, a battery pack current in No. 4 is a value with a charging side being +, and indicates a current at the time in No. 2. A battery pack SOC in No. 5 indicates a representative SOC of the battery pack. A series number N in a battery pack in No. 6 is a series number of cells illustrated in FIG. 2. The number M of temperature sensors in a battery pack in No. 7 is the number of temperature sensors illustrated in FIG. 2. An initial battery pack Ah capacity in No. 8 indicates a value of initial Ah $\times$ parallel number L of cells illustrated in FIG. 2. An initial battery pack energy capacity in No. 9 is calculated based on a value of cell initial energy capacity $\times$ series number N $\times$ parallel number L. No. 10 to No. N+9 indicate voltages of cells of the parallel number illustrated in FIG. 2. No. N+10 to No. N+M+9 indicate temperatures of temperature sensors.

The voltages and the temperatures are values measured at the time in No. 2. No. 6 to No. 9 are not necessarily essential for communication. When No. 6 to No. 9 are not present, it is assumed that information of No. 6 to No. 9 of each EV is present in the server.

The storage device 103 illustrated in FIG. 1 stores communication data (EV communication data) at regular time intervals as illustrated in FIG. 3.

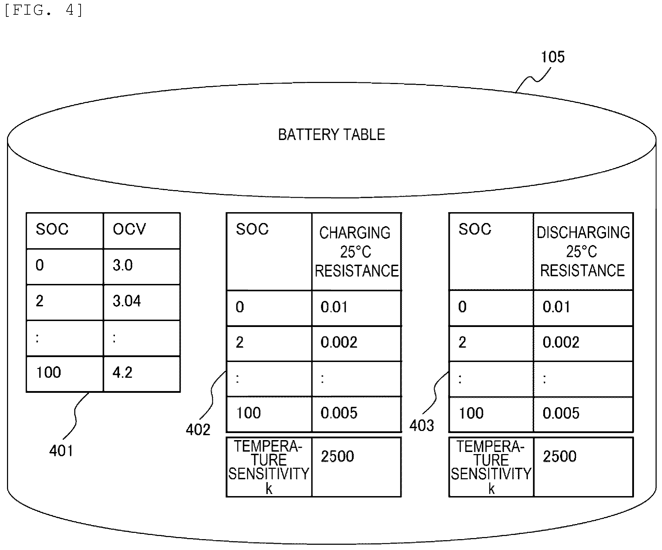

FIG. 4 is a configuration diagram illustrating an example of the battery table 105 illustrated in FIG. 1.

The battery table 105 illustrated in FIG. 4 is a table set in advance or set by the table setting unit 104, and is referred to by the battery pack energy calculation unit 106. The battery table 105 mainly includes an OCV table 401, a cell charging resistance table 402, and a cell discharging resistance table 403 in which values of OCV, charging resistance, and discharging resistance are collected for each SOC. Here, the OCV table 401 is a function having a value corresponding to each SOC, and the charging resistance and the discharging resistance are functions of an SOC and a temperature.

Next, the table setting unit 104 will be described.

The OCV table 401 is a table in which charging from a fully discharged state (SOC 0%) to SOC 2% and then waiting for 30 minutes are repeated until a fully charged state (SOC 100%) and a voltage after waiting for 30 minutes is defined as an OCV for each SOC.

A value in a right column of the cell charging resistance table 402 is a value obtained by subtracting $OCV_c$ which is an OCV corresponding to each SOC from a charging voltage $CCV_c$ corresponding to each SOC when a battery is charged from a fully discharged state to a fully charged state at 25°C and dividing the result by a current $I_c$, as expressed by the following formula (1).

$$(CCV_c - OCV_c) \diagup I_c \quad \cdots (1)$$

Here, a charging resistance $R_c(T_{cell})$ at a freely selected cell temperature $T_{cell}$ [°C] is expressed by the following formula (2).

$$R_c(Tcell) = \exp\{B \diagup (Tcell + 273.15) - B \diagup (25 + 273.15)\} \times R_c(25°C) \quad \cdots (2)$$

In the formula, $R_c(25°C)$ is a charging resistance $R_c(T_{cell})$ at $T_{cell}$ = 25°C. B is temperature sensitivity.
A value in a right column of the cell discharging resistance table 403 is a value obtained by subtracting $OCV_d$ which is an OCV corresponding to each SOC from a discharging voltage $CCV_d$ corresponding to each SOC when a battery is charged from a fully discharged state to a fully charged state at 25°C and dividing the result by a current $I_d$, as expressed by the following formula (3).

$$(CCV_d - OCV_d) \diagup I_d \quad \cdots (3)$$

Here, a charging resistance $R_d(T_{cell})$ at a freely selected cell temperature $T_{cell}$ [°C] is expressed by the following formula (4).

$$R_d(T_{cell}) = \exp\{B \diagup (T_{cell} + 273.15) - B \diagup (25 + 273.15)\} \times R_d(25°C) \quad \cdots (4)$$

In the formula, $R_d(25°C)$ is a discharging resistance $R_d(T_{cell})$ at $T_{cell}$ = 25°C. B is temperature sensitivity.
Although examples of the OCV table, the charging resistance table, and the discharging resistance table have been described above, a method for creating each table is not limited to the above-described method. Further, an SOC interval in each table is not limited to 2%, and any interval can be used.
Next, a method for diagnosing deterioration of a battery pack will be described. Here, the deterioration diagnosis is processing in the battery pack energy calculation unit 106 in FIG. 1, and in short, is processing of obtaining an energy capacity of a battery pack.
First, an SOC of each cell is obtained in a server, and then a charge capacity of each cell, an imbalance amount, an energy capacity of a battery pack at a current time, and an energy capacity in a state in which an imbalance is eliminated (a state in which the SOC of the whole battery is 100% when the battery pack is fully charged) are calculated.
Hereinafter, the battery pack energy calculation unit 106 illustrated in FIG. 1 will be specifically described.
First, an SOC of each cell is obtained by the SOC calculation unit 107, and SOC data is accumulated in a database (DB) of the SOC data group 108. Then, an energy capacity of the battery pack is obtained by the battery pack energy capacity calculation unit 109 using the SOC data group 108. The battery pack energy calculation unit 106 performs calculation based on data in the battery table 105 and the storage device 103.
The SOC calculation unit 107 and the battery pack energy capacity calculation unit 109 will be described below.
When a time interval of communication data is short (for example, 1 s or less), the SOC calculation unit 107 sets an interval of data for each traveling and each charging. On the other hand, when the time interval of the communication data is long, the SOC calculation unit 107 sets an interval of data during charging by a charger.

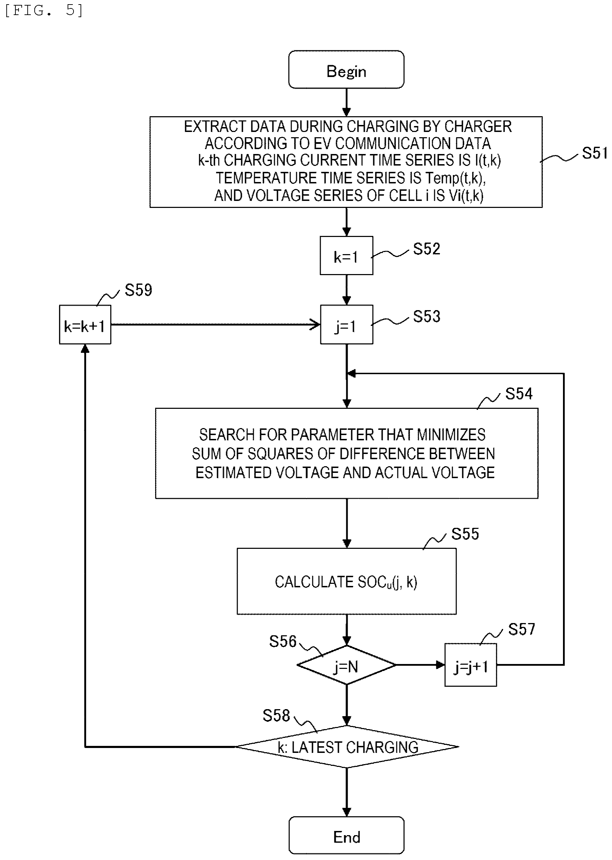

FIG. 5 is a flowchart illustrating an example of processing in the SOC calculation unit 107 illustrated in FIG. 1.
In FIG. 5, the processing in the SOC calculation unit 107 includes a charging data extraction step S51, a charging number initial setting step S52, a cell number initial setting step S53, an SOC solving step S54, a cell loop end determination step S56, a cell number up step S57, a charging number end determination step S58, and a charging number up step S59.
As illustrated in FIG. 5, in step S51, data (a current, a voltage of each cell, a temperature) during charging by a charger is acquired. These pieces of data are denoted by $I(t, k)$, $V_j(t, k)$, and $Temp(t, k)$ ($j = 1, \ldots N$). Here, t represents a time from the start of charging by the charger, and k represents the number of times of charging by the charger. j indicates a cell number. Since there are M temperature sensors, an average value of the M sensors may be used as Temp.
Next, in step S52, an earliest charging number (data during charging by the charger) k is set to 1. In step S53, the cell number j is set to 1.
In step S54, as expressed by the following formula (5), a parameter $P_j(k)$, $Q_j(k)$, $SOCI(j, k)$, $Q_{max}(j, k)$ that minimizes the sum of squares of a difference between an estimated voltage $Vest_j(t)$ of the cell j and an actual voltage $Vreal_j(t)$ of the cell j is obtained using the following formulas (6), (7), and (8).

$$\underset{P_j(k),Q_j(k),SOCI(j,k),Q_{max}(j,k)}{argmin} \int |Vest_j(t) - Vreal_j(t)|^2 dt \qquad \cdots (5)$$

$$Vreal_j(t) = OCV(SOC_j(t)) + R_c(Temp, SOC_j(t)) \times I(t) \qquad \cdots (6)$$

$$R_c(Temp, SOC) = \{P_j(k) \times R_{fc}(SOC) + Q_j(k)\} \times exp\{B/(Temp+273.15) - B/(25+273.15)\} \qquad \cdots (7)$$

$$SOC_j(t) = SOCI(j,k) + 100 \times \frac{\int I(t)\,dt}{Q_{max}(j,k)} \qquad \cdots (8)$$

Here, $P_j(k)$ is a coefficient of a charging resistance of each cell. $Q_j(k)$ is a coefficient of a charging resistance of each cell. $SOCI(j,k)$ is an initial value of the SOC of the cell j that is charged k times. $Q_{max}(j,k)$ is a charge capacity (Ah capacity) of the cell j. $R_{fc}(SOC)$ is a 25°C standard resistance function on a charging side. $R_c$ is a charging resistance of each cell. argmin in the above formula (5) is a function for obtaining a parameter that gives a minimum value. As an actual solution for obtaining argmin, a quasi-Newton method may be used.

Next, in step S55, an imbalance amount of the cell j (an SOC of each cell when a battery pack is fully charged) (hereinafter referred to as $SOC_u(j,k)$) is calculated.

Charges (charging) when the cell j is fully charged are expressed by the following formula. $SOCI_j$ is an initial SOC of the cell j, and $Qmax_j$ is a charge capacity (Ah capacity) of the cell j.

```
(1 - SOCIⱼ/100) × Qmaxⱼ
```

In a battery pack, when any one cell is fully charged, the battery pack is fully charged, and thus the battery pack is fully charged when a charge $Q_f$ expressed by the following formula is charged.

```
Qf = min[(1 - SOCIⱼ/100) × Qmaxⱼ]
```

Therefore, the SOC of each cell when the battery pack is fully charged is expressed by the following formula.

```
SOC = SOCIⱼ + 100 × Qf/Qmaxⱼ
```

The SOC of the cell j at this time is expressed as an imbalance amount ($SOC_u(j)$). When an imbalance state is eliminated, the imbalance amount is 100% in all cells. When the imbalance amount of all cells is 100%, an energy capacity of the battery pack is maximized.

Therefore, the calculation formula is expressed by the following formulas (9) and (10). The imbalance amount $SOC_u(j,k)$ of the cell j is an SOC of each cell when the battery pack is fully charged. $Q_f(k)$ is a charge (Ah) until the battery pack is fully charged, that is, any one cell is fully charged.

$$SOC_u(j,k) = 100 \frac{Q_f(k)}{Q_{max}(j,k)} + SOCI(j,k) \qquad \cdots (9)$$

$$Q_f(k) = \min_j \left\{ Q_{max}(j,k) \times \left(1 - \frac{SOCI(j,k)}{100}\right) \right\} \qquad \cdots (10)$$

Next, in step S56, it is determined whether the cell number j reaches the cell series number N. When the cell number is N, the processing proceeds to step S58. Otherwise, the cell number is incremented by one in step S57, and step S54 is repeated. In step S58, it is determined whether a charging number indicates latest charging, and if YES, the processing proceeds to step S59, and the processing proceeds to step S53. Otherwise, the processing ends.

The processing in FIG. 5 is periodically performed, for example, every day. In addition, charging data that was already processed is excluded. FIG. 5 illustrates processing for one vehicle, but when there are a plurality of vehicles, processing is performed for the number of vehicles.

After the processing illustrated in FIG. 5, not only an SOC time series of each cell but also an initial value and resistance coefficients $P_j(k)$, $Q_j(k)$, and $Q_{max}(j, k)$ for each charging of SOC are obtained. $P_j(k)$ and $Q_j(k)$ are constants in the above formula (4). These pieces of information are accumulated in the DB of the SOC data group 108.

Next, an SOC (expressed as $SOC_e(j)$) at which discharging of each cell j is stopped when discharging is performed at a constant current is obtained. Since the end of discharging of a battery pack is a time when any one of the cells reaches a lowest voltage $V_m$, $SOC_e(j)$ is obtained by solving the following nonlinear formula.

$$V_m = OCV(SOC_e(j)) - I_d \times R_d(SOC_e(j))$$

In the formula, $I_d$ is a discharging current, and $R_d$ is a current discharging resistance, and the formula is a function of SOC.

That is, $R_d$ is obtained by multiplying a standard value of a discharging resistance table stored in the battery table 105 by the above-described resistance coefficient $P_j$ and adding $Q_j$. When an initial value at the time of discharging is $SOC_u(j)$, a relationship of $SOC_e(j) = SOC_u(j) - 100 \times Q/Qmax_j$ is established, and thus discharging charge $Q_d(j)$ of the cell j is expressed by the following formula.

$$Q_d(j) = \{SOC_u(j) - SOC_e(j)\} \times Qmax_j/100$$

Since discharging of a battery pack is stopped when any one of the cells reaches the lowest voltage, discharging of the battery pack is stopped when $Q_d$ expressed by the following formula is discharged.

$$Q_d = min[\{SOC_u(j) - SOC_e(j)\} \times Qmax_j/100]$$

Therefore, an SOC range of the cell j is from $SOC_u(j)$ to $SOC_u(j) - 100 \times Q_d/Qmax_j$.

An average value $Va_j$ of a voltage $v_j(t)$ of the cell j in an integration range of the SOC is expressed by the following formula (11).

$$Va_j = \int \{OCV\left(SOC_j(t)\right) - I_d \times R_d\left(SOC_j(t)\right)\}dt \qquad \cdots (11)$$

Accordingly, an energy capacity $P_{max}$ of the battery pack can be calculated using the following formula (12).

$$P_{max} = \sum Va_j \times Qmax_j \qquad \cdots (12)$$

The above calculation result is a current battery pack energy capacity. Then, $SOC_u(j)$ is calculated as 100 in a similar manner to calculate a battery pack energy capacity after the imbalance is eliminated. These values can be calculated and a user can be notified of these values.

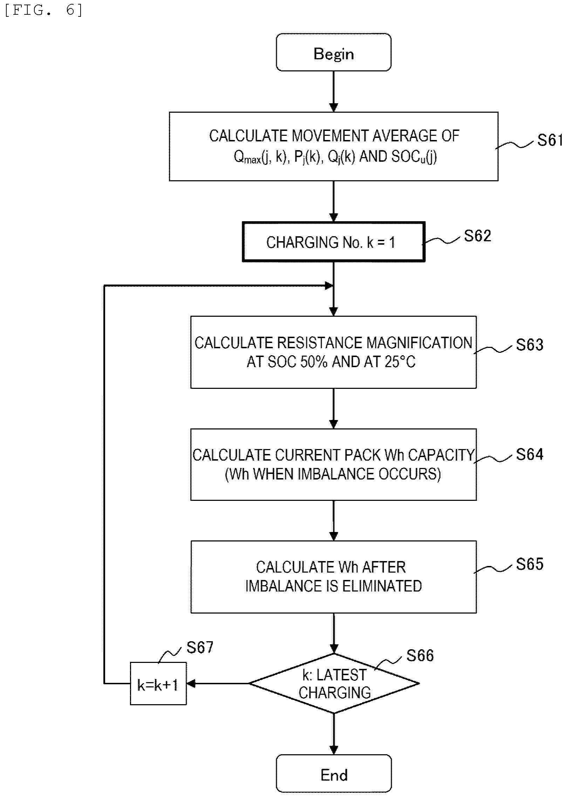

FIG. 6 is a flowchart illustrating an example of processing in the battery pack energy capacity calculation unit 109 illustrated in FIG. 1 under the above principle.

The processing in FIG. 6 does not need to be synchronized with the processing in FIG. 5, and may be calculated when a user wants to know an energy capacity of a battery pack, or may be calculated once a day or once a week.

The processing in FIG. 6 includes a movement average step S61, a charging number initial setting step S62, a cell number initial setting step S63, a current battery pack energy capacity calculation step S64, an imbalance eliminated energy capacity calculation step S65, a cell loop end step S66, and a cell number up step of S67.

First, in step S61, $Q_{max}(j, k)$ accumulated in the SOC data group 108 is calculated as a movement average value for k. At this time, the following formulas (13) and (14) are a ratio of "variance of SOC $\times$ number of data". The reason for setting the ratio of "SOC variance $\times$ number of data" is to reduce a weight $w_k$ of data having a large error because data having a small SOC change width or data with a small amount has a large error. Further, step S61 may be omitted.

$$Q_{max} = \sum_k Q_{max}(k)w_k \qquad \cdots (13)$$

$$w_k = \frac{\sum_{t \in N(k)}(SOC(k,t) - \overline{SOC(k)})^2}{\sum_k \sum_{t \in N(k)}(SOC(k,t) - \overline{SOC(k)})^2}$$

In the formula, N(k) is a time set included in charging data k.     $\cdots$ (14)

$\overline{SOC(k)}$ is a movement average value of SOC(k, t) in the time set N(k).

In step S61, movement average values are also calculated for $P_j(k)$, $Q_j(k)$ and $SOC_u(j)$ according to the same method as in formulas (13) and (14).

Next, in step S62, the charging number k is set to 1, and in step S63, from $P_j(k)$ and $Q_j(k)$, a magnification of how many times a current charging resistance of each cell at 25°C and at SOC 50% is compared to a standard charging resistance at 25°C and at SOC 50% is obtained. The magnification is regarded as the same as a magnification of a discharging resistance, and is used to obtain an energy capacity of a battery pack during discharging.

This can be obtained as $P_j(k) + Q_j(k)/R_f(SOC\ 50\%)$ using a standard resistance table $R_f(SOC)$ at 25°C. Although SOC 50% is used, SOC 50% is not necessarily essential, and any SOC value may be used as long as the discharging resistance and the charging resistance match.

Next, in step S64, a current battery pack energy capacity is calculated. This is to obtain an SOC (hereinafter referred to as $SOC_e(j)$) when the cell j reaches the lowest voltage $V_m$ in a case where each cell is discharged at a temperature Temp and with a constant discharging $I_d$. $SOC_e$ can be obtained from $SOC_u$. Specifically, when each cell is discharged, an SOC of each cell is obtained as $SOC_u(j, k)$ - 100Q/Q(j, k). Here, Q is a discharging Ah capacity of a battery pack. Since a voltage of each cell is OCV (SOC of cell j) - I × discharging resistance (temperature, SOC of cell j), a formula in which the voltage is $V_m$ may be solved.

A discharging resistance in this case is obtained by multiplying the standard resistance table at 25°C by a magnification of the charging resistance described above.

Then, cell voltages from $SOC_e(j)$ to $SOC_u(j)$ are integrated and multiplied by $Q_{max}(j, k)$ to obtain the sum.

Here, the calculation of battery pack charging charges will be described.

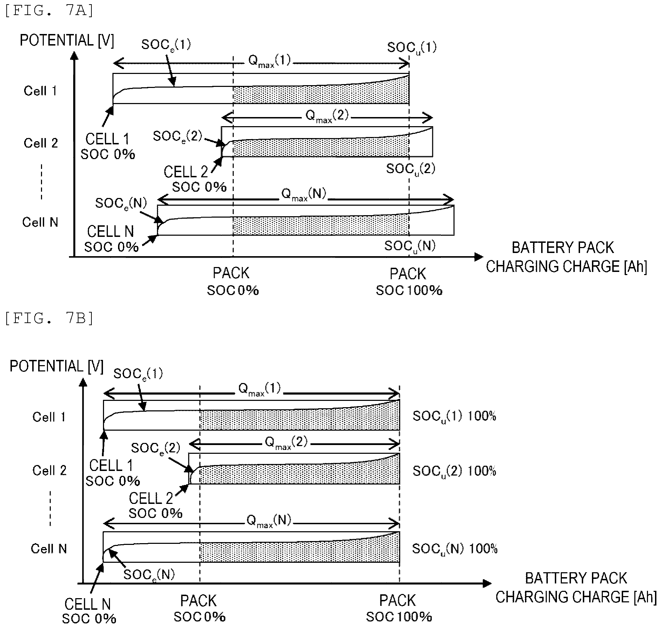

FIG. 7A is a graph illustrating a voltage of each cell in a state where an imbalance state occurs in a battery pack. A horizontal axis represents a discharging amount of the entire battery pack, and a vertical axis represents a voltage of each cell.

In FIG. 7A, a curve $SOC_e(j)$ of each cell j (j = 1, ... N) is illustrated. In general, left ends and right ends of the curves $SOC_e(j)$ do not coincide with one another. This is an imbalance state.

As illustrated in FIG. 7A, since the imbalance state among cells occurs, when the battery pack is fully charged, $SOC_u$ of the cells are not the same but are different values. When the battery pack becomes empty, an SOC of each cell becomes $SOC_e$. Therefore, an integrated value of cell voltages from $SOC_e$ to $SOC_u$ (portions shaded in gray in FIG. 7A) is an energy capacity of each cell. An energy capacity of the entire battery pack is calculated as the sum of the energy capacity of each cell.

In step S65 illustrated in FIG. 6, the energy capacity after the imbalance is eliminated is calculated.

Here, the battery pack energy capacity ($SOC_u(j)$ 100%) when the imbalance state is eliminated is calculated in the same manner.

FIG. 7B is a graph illustrating a voltage of each cell in a state after the imbalance state of the battery pack is eliminated.

As illustrated in FIG. 7B, when the imbalance state is eliminated, an integrated value of cell voltages from $SOC_e$ to $SOC_u$ increases, so that a usable energy capacity of the entire battery pack increases.

In step S66 illustrated in FIG. 6, whether charging is the latest charging is determined, and if NO, the charging number is incremented by one in step S67, and the processing proceeds to step S63.

When it is the latest charging number, the processing ends.

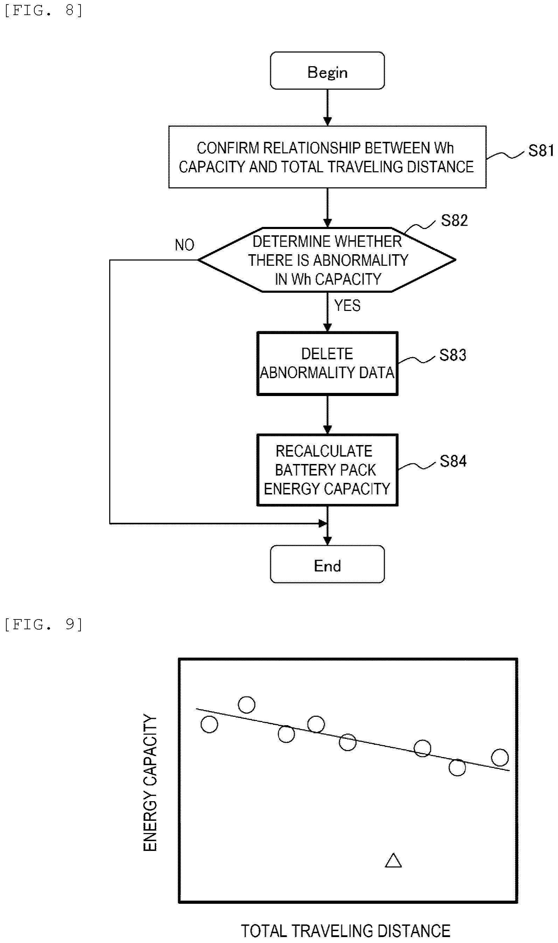

FIG. 8 is a flowchart illustrating an example of processing in the battery pack energy capacity diagnosis and recalculation unit 111 illustrated in FIG. 1.

In S81, a relationship between the calculated energy capacity (Wh capacity) and a total traveling distance is confirmed, and it is confirmed whether there is an abnormality in the calculated energy capacity. In S82, it is confirmed whether the result of S81 deviates from an overall tendency. When there is no deviated result, the processing ends. When there is a deviated result, in S83, a relationship between an energy capacity of the battery pack and input data is examined, the presence or absence of an abnormality in a specific temperature and a specific current is confirmed, and data that causes a specified abnormality is deleted. In S84, abnormality data is deleted, and the energy capacity of the battery pack is recalculated using only normal data.

FIG. 9 is an example of a graph used when diagnosing a value of the energy capacity of the battery pack in S82 illustrated in FIG. 8. A horizontal axis represents a total traveling distance of an EV, and a vertical axis represents an energy capacity of a battery pack. O represents a normal value, and △ represents an abnormal value.

As an example of a method for diagnosing a value of the calculated energy capacity of the battery pack, an approximate curve (obtained using all kinds of data) indicating a relationship between a total traveling distance and an energy capacity in a specific range is drawn as indicated by a solid curve in the graph illustrated in FIG. 9. Here, as the specific range, a period (a range up to one year before a current time), a total traveling distance (a range from a current distance up to 10,000 km), or the like can be specified. When an energy capacity of a battery calculated at a certain traveling distance is deviated from an energy capacity on the approximate curve by a preset allowable difference (δ) or more, the calculation result is regarded as abnormal. Subsequently, a result of recalculation performed by deleting a detected abnormal value is output.

The method for diagnosing the energy capacity calculated using the relationship between the total traveling distance and the energy capacity is included in a method for diagnosing the presence or absence of an abnormal value of the energy capacity using time-series data of the energy capacity of the battery pack.

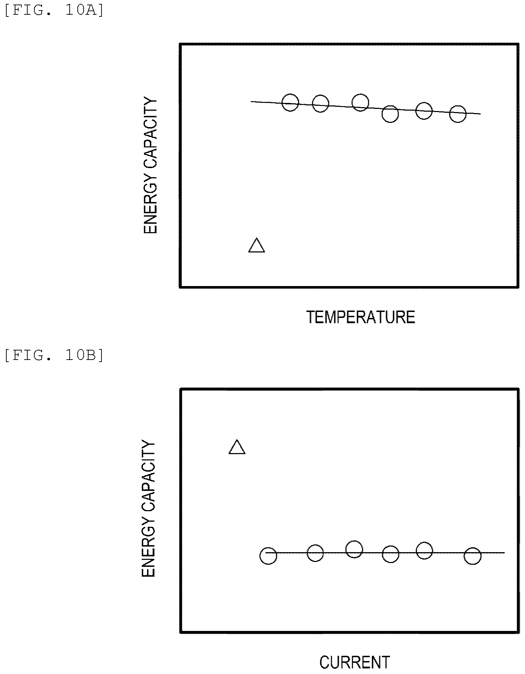

FIG. 10A is an example of a graph plotted under an abnormal value and a normal value classified as in FIG. 9 and a battery pack temperature condition at the time of diagnosis. A horizontal axis represents a temperature of the battery pack, and a vertical axis represents an energy capacity of the battery pack. O represents a normal value, and △ represents an abnormal value. In FIG. 10A, when abnormal values are unevenly present in a specific temperature region or lower, a temperature region in which an appearance probability of an abnormal value is equal to or higher than a predetermined probability threshold (α) is set as a condition in which a diagnosis abnormality occurs, and all results obtained by performing diagnosis based on data of the temperature region are regarded as abnormal. Subsequently, a result of recalculation performed by deleting a detected abnormal value is output.

FIG. 10B is an example of a graph plotted under an abnormal value and a normal value classified as in FIG. 9 and a current condition at the time of diagnosis. A horizontal axis represents a current at the time of diagnosis, and a vertical axis represents an energy capacity of a battery pack. O represents a normal value, and △ represents an abnormal value. In FIG. 10B, when abnormal values are unevenly present in a specific current region or lower, a current region in which an appearance probability of an abnormal value is equal to or higher than a predetermined probability threshold (β) is set as a condition in which a diagnosis abnormality occurs, and all results obtained by performing diagnosis based on data of the current region are regarded as abnormal. Subsequently, a result of recalculation performed by deleting a detected abnormal value is output.

Hereinafter, desired embodiments according to the present disclosure will be collectively described.

In the battery pack diagnosis method, the abnormality of a battery pack is diagnosed using time-series data of an energy capacity of the battery pack as whether there is an abnormal value of the energy capacity of the battery pack.

The battery pack diagnosis method further includes a step of comparing a relationship between an over-time change of the energy capacity of the battery pack and voltage data of each cell, and a step of detecting an abnormality of a voltage sensor based on a diagnosed abnormal value of the energy capacity of the battery pack.

The battery pack diagnosis method further includes a step of comparing a relationship between an over-time change of the energy capacity of the battery pack and current data, and a step of detecting an abnormality of a current sensor based on a diagnosed abnormal value of the energy capacity of the battery pack.

The battery pack diagnosis method further includes a step of comparing a relationship between an over-time change of the energy capacity of the battery pack and temperature data, and a step of detecting an abnormality of a temperature sensor based on a diagnosed abnormal value of the energy capacity of the battery pack.

The battery pack is installed in a vehicle, and an abnormality of the battery pack is diagnosed based on a relational expression between the energy capacity of the battery pack and a total traveling distance of the vehicle.

The battery pack diagnosis method further includes a step of notifying a user of the battery pack of a diagnosis result regarding the presence or absence of an abnormality.

A battery pack diagnosis device obtains detection data including a current and a temperature of a battery pack having a configuration in which a plurality of cells are connected in series and a voltage of each of the cells, obtains function data of an OCV and a resistance which are functions of an SOC of a cell, creates a resistance table of each of the cells using the function data and the detection data, calculates an SOC of each of the cells using the current, the temperature, and the voltage of each of the cells, calculates a charge capacity of each cell, a resistance, and an SOC difference, calculates an energy capacity of the battery pack using the charge capacity, the SOC difference, and the resistance, diagnoses an abnormality of the battery pack, deletes data diagnosed as the abnormality, and recalculates an energy capacity of the battery pack.

In the battery pack diagnosis device, the battery pack is installed outside a diagnosis device, and the battery pack and the diagnosis device are communicably connected to each other. In this case, a communication unit may be wired or wireless, and the Internet or the like may be used.

Hereinafter, effects obtained from the present disclosure will be collectively described.

An energy capacity of a battery pack can be calculated by detecting data of a voltage, a current, and a temperature of the battery using a sensor installed in an EV and by using a separately created algorithm and table.

Further, by diagnosing time-series data of the calculated energy capacity of the battery pack, the presence or absence of an abnormality in input data can be diagnosed, and when there is an abnormality, the energy capacity of the battery pack can be calculated with high accuracy by performing recalculation by deleting abnormality data.

Reference Signs List

| | |
|---|---|
| 100: | server |
| 101: | electric vehicle |
| 102: | communication device |
| 103: | storage device |
| 104: | table setting unit |
| 105: | battery table |
| 106: | battery pack energy calculation unit |
| 107: | SOC calculation unit |
| 108: | SOC data group |
| 109: | battery pack energy capacity calculation unit |
| 110: | data group of energy capacity, voltage, current, temperature of battery pack |
| 111: | energy capacity diagnosis and recalculation unit |
| 112: | battery pack energy capacity data group |
| 201: | cell |
| 202: | temperature sensor |
| 203: | cell group |
| 204: | ammeter |
| 205: | battery management unit |
| 206: | network |
| 401: | OCV Table |
| 402: | cell charging resistance table |
| 403: | cell discharging resistance table |
| S51: | charging data extraction step |
| S52: | charging number initial setting step |
| S53: | cell number initial setting step |
| S54: | SOC solving step |
| S56: | cell loop end determination step |
| S57: | cell number up step |
| S58: | charging number end determination step |
| S59: | charging number up step |
| S61: | movement average step |
| S62: | charging number initial setting step |
| S63: | cell number initial setting step |
| S64: | current battery pack energy capacity calculation step |
| S65: | imbalance eliminated energy capacity calculation step |
| S66: | cell loop end step |
| S67: | cell number up step |
| S81: | energy capacity and traveling distance relationship confirmation step |
| S82: | abnormal diagnosis result presence or absence determination step |
| S83: | abnormality data deletion step |
| S84: | battery pack energy capacity recalculation step |

**Claims**

1. A battery pack diagnosis method comprising:

a step of obtaining detection data including a current and a temperature of a battery pack having a configuration in which a plurality of cells are connected in series and a voltage of each of the cells;
a step of obtaining function data of an open circuit voltage and a resistance which are functions of a charging state of each of the cells;

a step of creating a resistance table of each of the cells using the function data and the detection data;
a step of calculating the charging state of each of the cells using the current, the temperature, and the voltage of each of the cells;
a step of calculating a charge capacity of each of the cells, the resistance, and a charging state per cell;
a step of calculating an energy capacity of the battery pack using the charge capacity, the charging state per cell, and the resistance;
a step of diagnosing a value of the calculated energy capacity of the battery pack; and
a step of deleting a value of the energy capacity determined to be an abnormality by the diagnosis and recalculating the energy capacity of the battery pack.

2. The diagnosis method according to claim 1, wherein
the abnormality is diagnosed as presence or absence of an abnormality in a newly calculated energy capacity using a value of the energy capacity calculated in a specific range.

3. The diagnosis method according to claim 2, further comprising:

a step of comparing a relationship between an over-time change of the energy capacity of the battery pack and data of the current; and
a step of determining a current range of data used for diagnosis based on a diagnosed abnormal value of the energy capacity of the battery pack.

4. The diagnosis method according to claim 2, further comprising:

a step of comparing a relationship between an over-time change of the energy capacity of the battery pack and data of the temperature; and
a step of determining a temperature range of data used for diagnosis based on a diagnosed abnormal value of the energy capacity of the battery pack.

5. The diagnosis method according to claim 1, wherein

the battery pack is installed in a vehicle, and
the abnormality of the battery pack is diagnosed based on a relational expression between the energy capacity of the battery pack and a total traveling distance of the vehicle.

6. The diagnosis method according to claim 1, further comprising:
a step of notifying a user of the battery pack of a diagnosis result regarding the presence or absence of the abnormality.

7. A battery pack diagnosis device configured to:

obtain detection data including a current and a temperature of a battery pack having a configuration in which a plurality of cells are connected in series and a voltage of each of the cells;
obtain function data of an open circuit voltage and a resistance which are functions of a charging state of each of the cells;
create a resistance table of each of the cells using the function data and the detection data;
calculate the charging state of each of the cells using the current, the temperature, and the voltage of each of the cells;
calculate a charge capacity of each of the cells, the resistance, and a charging state per cell;
calculate an energy capacity of the battery pack using the charge capacity, the charging state per cell, and the resistance;
diagnose a value of the calculated energy capacity of the battery pack; and
delete a value of the energy capacity determined to be an abnormality by the diagnosis and recalculating the energy capacity of the battery pack.

8. The diagnosis device according to claim 7, wherein

the battery pack is installed outside the diagnosis device, and
the battery pack and the diagnosis device are communicably connected to each other.

[FIG. 1]

[FIG. 2]

[FIG. 3]

| No. | ITEM | VALUE |
|---|---|---|
| 1 | VEHICLE ID | 12345 |
| 2 | TIME | 2022/1/1 12:00:00 |
| 3 | VEHICLE STATE FLAG | CHARGING |
| 4 | BATTERY PACK CURRENT [A] (CHARGING: +, DISCHARGING: -) | 10 |
| 5 | BATTERY PACK SOC [%] | 40 |
| 6 | SERIES NUMBER N IN BATTERY PACK | 100 |
| 7 | NUMBER OF TEMPERATURE SENSORS M IN BATTERY PACK | 10 |
| 8 | INITIAL PACK Ah CAPACITY [Ah] | 20 |
| 9 | INITIAL PACK ENERGY CAPACITY [kWh] | 50 |
| 10 | VOLTAGE OF BATTERY 1 (V) | 3.52 |
| 11 | VOLTAGE OF BATTERY 2 (V) | 3.49 |
| : | : | : |
| N+9 | VOLTAGE OF BATTERY N (V) | 3.49 |
| N+10 | TEMPERATURE OF THERMOMETER 1 [°C] | 23.9 |
| : | : | : |
| N+M+9 | TEMPERATURE OF THERMOMETER M [°C] | 24.1 |

[FIG. 4]

**BATTERY TABLE** — 105

| SOC | OCV |
|-----|-----|
| 0 | 3.0 |
| 2 | 3.04 |
| : | : |
| 100 | 4.2 |

401

| SOC | CHARGING 25°C RESISTANCE |
|-----|--------------------------|
| 0 | 0.01 |
| 2 | 0.002 |
| : | : |
| 100 | 0.005 |
| TEMPERA-TURE SENSITIVITY k | 2500 |

402

| SOC | DISCHARGING 25°C RESISTANCE |
|-----|------------------------------|
| 0 | 0.01 |
| 2 | 0.002 |
| : | : |
| 100 | 0.005 |
| TEMPERA-TURE SENSITIVITY k | 2500 |

403

[FIG. 5]

[FIG. 6]

```
                    ┌──────────┐
                    │  Begin   │
                    └────┬─────┘
                         │
          ┌──────────────▼──────────────────┐
          │ CALCULATE MOVEMENT AVERAGE OF    │ ⟋ S61
          │ Qmax(j, k), Pj(k), Qj(k) AND     │
          │ SOCu(j)                          │
          └──────────────┬──────────────────┘
                         │
          ┌──────────────▼──────────────────┐
          │     CHARGING No. k = 1           │ ⟋ S62
          └──────────────┬──────────────────┘
                         │
          ┌──────────────▼──────────────────┐
          │ CALCULATE RESISTANCE             │ ⟋ S63
          │ MAGNIFICATION AT SOC 50%         │
          │ AND AT 25°C                      │
          └──────────────┬──────────────────┘
                         │
          ┌──────────────▼──────────────────┐
          │ CALCULATE CURRENT PACK Wh        │ ⟋ S64
          │ CAPACITY (Wh WHEN IMBALANCE      │
          │ OCCURS)                          │
          └──────────────┬──────────────────┘
                         │
          ┌──────────────▼──────────────────┐
          │ CALCULATE Wh AFTER               │ ⟋ S65
          │ IMBALANCE IS ELIMINATED          │
          └──────────────┬──────────────────┘
                         │
   ┌────────┐      ┌──────▼──────┐
   │ k=k+1  │◄─────│ k: LATEST   │ ⟋ S66
   └────────┘      │  CHARGING   │
    ⟋ S67          └──────┬──────┘
                         │
                    ┌────▼─────┐
                    │   End    │
                    └──────────┘
```

[FIG. 7A]

[FIG. 7B]

[FIG. 8]

```
                    ┌─────────────┐
                    │    Begin    │
                    └──────┬──────┘
                           │
                           ▼
        ┌──────────────────────────────────────┐
        │  CONFIRM RELATIONSHIP BETWEEN Wh       │  ⌐ S81
        │  CAPACITY AND TOTAL TRAVELING DISTANCE │
        └──────────────────┬───────────────────┘
                           │
                           ▼                        ⌐ S82
              ╱────────────────────────╲
       NO    ╱   DETERMINE WHETHER       ╲
     ┌──────┤    THERE IS ABNORMALITY     │
     │       ╲    IN Wh CAPACITY         ╱
     │        ╲────────────┬───────────╱
     │                     │ YES
     │                     ▼
     │            ┌──────────────────┐
     │            │     DELETE        │  ⌐ S83
     │            │ ABNORMALITY DATA  │
     │            └────────┬─────────┘
     │                     │
     │                     ▼
     │            ┌──────────────────┐
     │            │   RECALCULATE     │  ⌐ S84
     │            │  BATTERY PACK     │
     │            │  ENERGY CAPACITY  │
     │            └────────┬─────────┘
     │                     │
     └─────────────────────┤
                           ▼
                    ┌─────────────┐
                    │     End     │
                    └─────────────┘
```

[FIG. 9]

TOTAL TRAVELING DISTANCE

[FIG. 10A]

TEMPERATURE

[FIG. 10B]

CURRENT

## INTERNATIONAL SEARCH REPORT

| International application No. |
| --- |
| **PCT/JP2024/002188** |

**A.    CLASSIFICATION OF SUBJECT MATTER**

*G01R 31/392*(2019.01)i; *G01R 31/367*(2019.01)i; *G01R 31/3828*(2019.01)i; *G01R 31/388*(2019.01)i; *G01R 31/389*(2019.01)i; *G01R 31/396*(2019.01)i; *H01M 10/48*(2006.01)i; *H02J 7/00*(2006.01)i

FI:    G01R31/392; G01R31/367; G01R31/3828; G01R31/388; G01R31/389; G01R31/396; H01M10/48 P; H01M10/48 301; H02J7/00 Y

According to International Patent Classification (IPC) or to both national classification and IPC

**B.    FIELDS SEARCHED**

Minimum documentation searched (classification system followed by classification symbols)

G01R31/36 - 31/392; 31/00 - 31/24 - 31/25; 31/40 - 31/44; H01M10/42 - 10/48; H02J7/00 - 7/12; 7/34 - 7/36; B60L 1/00 - 3/12; 7/00 - 13/00; 15/00 - 58/40

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| Y | WO 2022/024885 A1 (HITACHI HIGH TECH CORP.) 03 February 2022 (2022-02-03) paragraphs [0001], [0017]-[0018], [0023]-[0025], [0033], [0039]-[0044], [0048]-[0076], [0093]-[0098], fig. 1-2, 4-6 | 1-2, 7-8 |
| Y | JP 2020-65424 A (TOYOTA JIDOSHA KABUSHIKI KAISHA) 23 April 2020 (2020-04-23) paragraph [0062], fig. 3 | 1-2, 7-8 |
| Y | JP 2022-170227 A (HITACHI HIGH TECH CORP.) 10 November 2022 (2022-11-10) paragraphs [0039]-[0042], fig. 10-12 | 1-2, 7-8 |
| Y | JP 2013-090344 A (HITACHI, LTD.) 13 May 2013 (2013-05-13) paragraph [0027], fig. 15-16 | 1-2, 7-8 |
| A | JP 2016-090485 A (HITACHI, LTD.) 23 May 2016 (2016-05-23) entire text, all drawings | 1-8 |

☑ Further documents are listed in the continuation of Box C.      ☑ See patent family annex.

| | |
| --- | --- |
| *    Special categories of cited documents: | "T"    later document published after the international filing date or priority date and not in conflict with the application but cited to understand the principle or theory underlying the invention |
| "A"    document defining the general state of the art which is not considered to be of particular relevance | |
| "D"    document cited by the applicant in the international application | "X"    document of particular relevance; the claimed invention cannot be considered novel or cannot be considered to involve an inventive step when the document is taken alone |
| "E"    earlier application or patent but published on or after the international filing date | |
| "L"    document which may throw doubts on priority claim(s) or which is cited to establish the publication date of another citation or other special reason (as specified) | "Y"    document of particular relevance; the claimed invention cannot be considered to involve an inventive step when the document is combined with one or more other such documents, such combination being obvious to a person skilled in the art |
| "O"    document referring to an oral disclosure, use, exhibition or other means | "&"    document member of the same patent family |
| "P"    document published prior to the international filing date but later than the priority date claimed | |

| Date of the actual completion of the international search | Date of mailing of the international search report |
| --- | --- |
| **12 March 2024** | **26 March 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**

International application No.

**PCT/JP2024/002188**

C.      DOCUMENTS CONSIDERED TO BE RELEVANT

| Category* | Citation of document, with indication, where appropriate, of the relevant passages | Relevant to claim No. |
|---|---|---|
| A | WO 2012/172686 A1 (TOYOTA JIDOSHA KABUSHIKI KAISHA) 20 December 2012 (2012-12-20)<br>entire text, all drawings | 1-8 |
| A | JP 2008-547365 A (LG CHEM, LTD.) 25 December 2008 (2008-12-25)<br>entire text, all drawings | 1-8 |
| A | KR 2003-0045487 A (HUANG, Yung Sheng) 11 June 2003 (2003-06-11)<br>entire text, all drawings | 1-8 |

Form PCT/ISA/210 (second sheet) (July 2022)

## INTERNATIONAL SEARCH REPORT
### Information on patent family members

International application No.

**PCT/JP2024/002188**

| Patent document cited in search report | | | Publication date (day/month/year) | Patent family member(s) | | | Publication date (day/month/year) |
|---|---|---|---|---|---|---|---|
| WO | 2022/024885 | A1 | 03 February 2022 | US | 2023/0204675 | A1 | |
| | | | | paragraphs [0001], [0029]-[0030], [0035]-[0038], [0045], [0050]-[0055], [0059]-[0080], [0096]-[0101], fig. 1-2, 4-6 | | | |
| | | | | EP | 4191745 | A1 | |
| | | | | CN | 115835974 | A | |
| JP | 2020-65424 | A | 23 April 2020 | US | 2020/0126516 | A1 | |
| | | | | paragraph [0068], fig. 3 | | | |
| | | | | EP | 3640071 | A1 | |
| | | | | CN | 111071097 | A | |
| JP | 2022-170227 | A | 10 November 2022 | CN | 117222904 | A | |
| | | | | WO | 2022/230335 | A1 | |
| JP | 2013-090344 | A | 13 May 2013 | WO | 2013/054573 | A1 | |
| JP | 2016-090485 | A | 23 May 2016 | (Family: none) | | | |
| WO | 2012/172686 | A1 | 20 December 2012 | US | 2014/0132214 | A1 | |
| | | | | entire text, all drawings | | | |
| | | | | CN | 103635350 | A | |
| | | | | KR | 10-2014-0023434 | A | |
| JP | 2008-547365 | A | 25 December 2008 | US | 2006/0284614 | A1 | |
| | | | | entire text, all drawings | | | |
| | | | | WO | 2006/135192 | A1 | |
| | | | | KR | 10-2006-0130509 | A | |
| | | | | CN | 101199096 | A | |
| KR | 2003-0045487 | A | 11 June 2003 | (Family: none) | | | |

Form PCT/ISA/210 (patent family annex) (July 2022)

**EP 4 679 114 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2022024885 A